# EUROPEAN PATENT APPLICATION

(11) **EP 3 154 078 A2**
(43) Date of publication of application: **12.04.2017**
(21) Application number: 16184667.0
(22) Date of filing: 18.08.2016
(51) Int. Cl.: H01L 21/56

(54) **FAN-OUT WAFER LEVEL PACKAGE STRUCTURE**

(30) Priority: 05.10.2015 US 201562237233 P; 05.10.2015 US 201562237239 P; 05.10.2015 US 201562237259 P; 15.07.2016 US 201615212113
(71) Applicant: MediaTek Inc., Hsin-Chu 300 (TW)
(72) Inventor: LIU, Nai-Wei, 830 Kaohsiung City (TW); LIN, Tzu-Hung, 302 Zhubei City, Hsinchu County (TW); PENG, I-Hsuan, 300 Hsinchu City (TW); HSIAO, Ching-Wen, Hsinchu City 300 (TW); HUANG, Wei-Che, 310 Hsinchu County (TW)
(74) Representative: Goddar, Heinz J.

(57) **Abstract**

A semiconductor package structure is provided. The structure includes a molding compound (100) having a dicing lane region (L). A semiconductor die (200) is disposed in the molding compound and surrounded by the dicing lane region. The semiconductor die has a first surface (200a) and a second surface (200b) opposite thereto, and the first and second surfaces are exposed from the molding compound. The structure further includes a redistribution layer (RDL) structure (102) disposed on the first surface of the semiconductor die and covering the molding compound. The RDL structure includes a photosensitive material (102a) and has an opening (103) aligned with the dicing lane region.

## Description

### CROSS REFERENCE TO RELATED APPLICATIONS

This application claims the benefit of U.S. Provisional Application No. 62/237,233 filed October 5, 2015, U.S. Provisional Application No. 62/237,239 filed October 5, 2015, and U.S. Provisional Application No. 62/237,259 filed October 5, 2015, the entirety of which are incorporated by reference herein.

### BACKGROUND OF THE INVENTION

### Field of the Invention

The present invention relates to a semiconductor package structure, and in particular to a fan-out wafer level package structure with high reliability.

### Description of the Related Art

In recent years, as electronic products have been become increasingly multifunctional and have been scaled down in size, there is a desire for manufactures of semiconductor devices to make more devices be formed on a single semiconductor wafer, so that the electronic products including these devices can be made more compact. Responses to this desire have been the development of the Package-on-package (PoP) technique and wafer level package (WLP) technique. The PoP technique enables two or more packages to be installed atop one another, i.e. stacked, with a standard interface to route signals between them. This allows higher component density in electronic products, such as mobile phones, personal digital assistants (PDAs), and digital cameras. Moreover, in the WLP, the dies may be same size as the package.

However, some problems may occur while manufacturing the semiconductor package utilizing the PoP and/or WLP techniques. For example, while performing a dicing process to produce individual package structures, the mechanical saw may be contaminated by the interconnect layer (which is sometimes referred to as the redistribution layer (RDL)) including a polymer formed in the package structure. Moreover, in the dicing process, there is a need to first performing a laser grooving process to remove the interconnect layer on the dicing lanes, thereby preventing the interconnect layer from cracking due to mechanical dicing. As a result, the manufacturing cost is increased. Additionally, in the manufacture of a semiconductor package, insufficient bonding force for die attachment and poor adhesion between molding compound and the through via therein may reduce reliability, yield, and throughput of the semiconductor package structure.

Thus, a novel semiconductor package structure is desirable.

### BRIEF SUMMARY OF THE INVENTION

A semiconductor package structure is provided. An exemplary embodiment of a semiconductor package structure includes a molding compound having a dicing lane region. A semiconductor die is disposed in the molding compound and surrounded by the dicing lane region. The semiconductor die has a first surface and a second surface opposite thereto, and the first and second surfaces are exposed from the molding compound. A redistribution layer (RDL) structure is disposed on the first surface of the semiconductor die and covers the molding compound. The RDL structure includes a photo-sensitive material and has an opening aligned with the dicing lane region.

Another exemplary embodiment of a semiconductor package structure includes a molding compound having a dicing lane region. A semiconductor die is disposed in the molding compound and surrounded by the dicing lane region. The semiconductor die has a first surface and a second surface opposite thereto, and the first and second surfaces are exposed from the molding compound. A redistribution layer (RDL) structure is disposed on the first surface of the semiconductor die and covers the molding compound. The RDL structure includes a photo-sensitive material and has an opening aligned with the dicing lane region. A U-shaped adhesion layer is disposed on the second surface of the semiconductor die. The U-shaped adhesion layer has a plate portion and a wall portion on an edge of the plate portion, such that the wall portion covers a portion of a sidewall of the semiconductor die.

Yet another exemplary embodiment of a semiconductor package structure includes a molding compound having a dicing lane region. A semiconductor die is disposed in the molding compound and surrounded by the dicing lane region. The semiconductor die has a first surface and a second surface opposite thereto, and the first and second surfaces are exposed from the molding compound. A redistribution layer (RDL) structure is disposed on the first surface of the semiconductor die and covers the molding compound. The RDL structure includes a photo-sensitive material and has an opening aligned with the dicing lane region. At least one through via passes through the molding compound and is electrically coupled to the RDL structure. A barrier layer is disposed between the molding compound and the at least one through via

A detailed description is given in the following embodiments with reference to the accompanying drawings.

### BRIEF DESCRIPTION OF THE DRAWINGS

The present invention can be more fully understood by reading the subsequent detailed description and examples with references made to the accompanying drawings, wherein:
FIG. 1 is a cross-sectional view of a semiconductor package structure in accordance with some embodiments of the disclosure.
FIG. 2 is a cross-sectional view of a semiconductor package structure in accordance with some embodiments of the disclosure.
FIG. 3 is a cross-sectional view of a semiconductor package structure in accordance with some embodiments of the disclosure.
FIG. 4 is a cross-sectional view of a semiconductor package structure in accordance with some embodiments of the disclosure.
FIG. 5 is a cross-sectional view of a semiconductor package structure in accordance with some embodiments of the disclosure.
FIG. 6 is a cross-sectional view of a semiconductor package structure in accordance with some embodiments of the disclosure.
FIG. 7 is a cross-sectional view of a semiconductor package structure in accordance with some embodiments of the disclosure.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is determined by reference to the appended claims.

The present invention will be described with respect to particular embodiments and with reference to certain drawings, but the invention is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the invention.

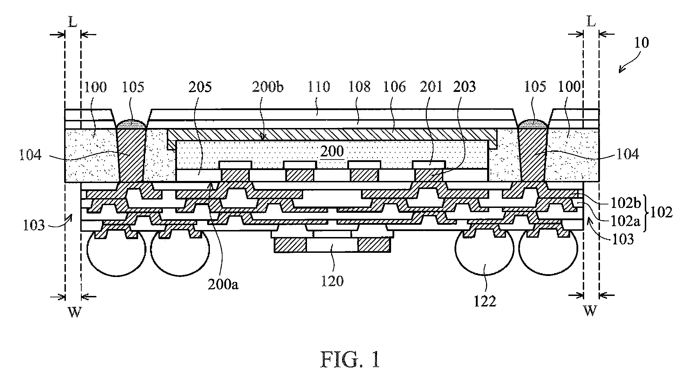

FIG. 1 is a cross-sectional view of a semiconductor package structure 10 in accordance with some embodiments of the disclosure. In some embodiments, the semiconductor package structure 10 is a wafer-level semiconductor package structure, for example, a fan-out wafer-level semiconductor package structure. In one embodiment, the fan-out wafer-level semiconductor package structure may be a system-on-chip (SOC) package structure and a dynamic random access memory (DRAM) package structure (not shown) may be vertically stacked thereon.

Referring to FIG. 1, the semiconductor package structure 10 is mounted on a base (not shown), such as a printed circuit board (PCB), that is formed of polypropylene (PP).

In some embodiments, the base serves as a package substrate and may be a single layer or a multilayer structure. Conductive pads and conductive traces electrically coupled thereto are typically disposed on the top surface of the base and/or in the base. In this case, the conductive traces may are used for the input/output (I/O) connections of the semiconductor package structure 10. In one embodiment, the semiconductor package structure 10 is mounted directly on the conductive traces.

The semiconductor package structure 10 is mounted on the base by a bonding process. For example, the semiconductor package structure 10 includes a plurality of conductive structures 122 that is mounted on and electrically coupled to the base by the bonding process. In some embodiments, the conductive structures 122 may comprise conductive bumps (such as copper or solder bumps), conductive pillars, or conductive paste structures.

In the embodiment, the semiconductor package structure 10 includes a molding compound 100, a semiconductor die 200 (such as a SOC die), and an RDL structure 102. The molding compound 100 has a dicing lane region L. In some embodiments, the molding compound 100 may be formed of an epoxy, a resin, a moldable polymer, or the like. The molding compound 100 may be applied while substantially liquid, and then may be cured through a chemical reaction, such as in an epoxy or resin. In some other embodiments, the molding compound 100 may be an ultraviolet (UV) or thermally cured polymer applied as a gel or malleable solid capable of being disposed around the semiconductor die 200, and then may be cured through a UV or thermal curing process. The molding compound 100 may be cured with a mold (not shown).

In some embodiments, the semiconductor die 200 is disposed in the molding compound 100 and surrounded by the dicing lane region L. The semiconductor die 200 has a first surface 200a and a second surface 200b opposite thereto. The first and second surfaces 200a and 200b are exposed from the molding compound 100. Moreover, the semiconductor die 200 may include pads 201 that are electrically connected to the circuitry (not shown) of the semiconductor die 200. In some embodiments, the semiconductor die 200 (such as a SOC die) may include a logic die including a central processing unit (CPU), a graphics processing unit (GPU), a dynamic random access memory (DRAM) controller or any combination thereof. In some embodiments, pads 201 of the semiconductor die 200 are in contact with the corresponding conductive structures 203 (for example, conductive bumps, pillars or solder pastes) that are disposed in a passivation layer 205 of the semiconductor die 200 and near the first surface 200a.

In some embodiments, the RDL structure 102, which is also referred to as a fan-out structure, is disposed on the first surface 200a of the semiconductor die 200 and covers the molding compound 100. The RDL structure 102 is connected to the semiconductor die 200 through the conductive structures 203.

In the embodiment, the RDL structure 102 includes one or more conductive traces 102b disposed in an inter-metal dielectric (IMD) layer 102a. The conductive traces 102b are disposed at multiple layer-levels of the IMD layer 102a and electrically coupled to the semiconductor die 200. Moreover, the IMD layer 102a of the RDL structure 102 has an opening 103 aligned with the dicing lane region L of the molding compound 100. In some embodiments, the IMD layer 102a is formed of an organic material, which includes a polymer base material or the like. For example, the IMD layer 102a is made of a photo-sensitive material, which includes a dry film photoresist, or a taping film. In this case, the opening 103 is formed by lithography including exposure and development processes.

In the embodiment, the opening 103 passes through the RDL structure 102, so that the molding compound 100 corresponding to the dicing lane region L is exposed by the opening 103. In some embodiments, the opening 103 has a width W in a range of about 1µm to 100µm. Such an opening 103 prevents the RDL structure 102 from cracking while performing a dicing process. Moreover, the opening 103 also allows the mechanical saw without contacting the sidewall thereof while performing a dicing process, thereby preventing polymer residues from being generated from the RDL structure 102. As a result, it ensures that the mechanical saw is not contaminated by the polymer residues.

In the embodiment, the semiconductor package structure 10 further includes a passive device 120 disposed on the RDL structure 102 and electrically coupled thereto by the conductive traces 102b therein. Also, the plurality of conductive structures 122 is disposed on the RDL structure 102 and electrically coupled thereto by the conductive traces 102b therein.

In some embodiments, the molding compound 100 includes one or more through vias 104 (which are sometimes referred to as through package vias (TPVs) or through interposer vias (TIVs)) passing through the molding compound 100 and electrically coupled to the RDL structure 102 by the conductive traces 102b therein. In some embodiments, the semiconductor die 200 may be surrounded by the through vias 104. Moreover, the through vias 104 may be formed of copper.

In the embodiment, the semiconductor package structure 10 further includes an adhesion layer 106, a first protective layer 110, and a second protective layer 108. The adhesion layer 106 (which is sometimes referred to as a die-attach film (DAF)) is used for attaching the semiconductor die 200 onto a carrier (not shown) during fabrication of the semiconductor package structure 10. In some embodiments, the adhesion layer 106 is surrounded by the molding compound 100.

The first protective layer 110 (which is sometimes referred to as a back side film (BSF)) is disposed over the second surface 200b of the semiconductor die 200 and the molding compound 100, so that the adhesion layer 106 is disposed between the first protective layer 110 and the semiconductor die 200. The first protective layer 110 protects the semiconductor die 200 and the molding compound 100 from being damaged. The second protective layer 108 is disposed over the second surface 200b of the semiconductor die 200 and the molding compound 100 and between the first protective layer 110 and the adhesion layer 106. The second protective layer 108 protects the underlying adhesion layer 106 from being damaged during forming the through vias 104. In some embodiments, the first and second protective layers 110 and 118 have openings, respectively, to expose the through via(s) 104 in the molding compound 100. Moreover, an optional solder material 105 may fill these openings to contact the exposed through via 104, thereby facilitating the bonding process for PoP fabrication. In some embodiments, there is not through vias formed in the molding compound 100. In this case, the second protective layer 108 can be removed, such that the first protective layer 110 is in direct contact with the adhesion layer 106.

According to the foregoing embodiments, since the RDL structure has an opening defined by lithography to expose the molding compound corresponding to the dicing lane region, it does not need to perform a laser grooving process prior to the dicing process using a mechanical saw. As a result, the manufacturing cost can be reduced and the processes for the semiconductor package structure can be simplified. Moreover, while performing the dicing process, polymer residues generated from the polymer-containing RDL structure can be eliminated or mitigated, thereby preventing the mechanical saw from being contaminated. Additionally, since the opening makes the RDL structure create a discontinuity surface, the warpage in the semiconductor package structure can be mitigated or improved by stress reduction.

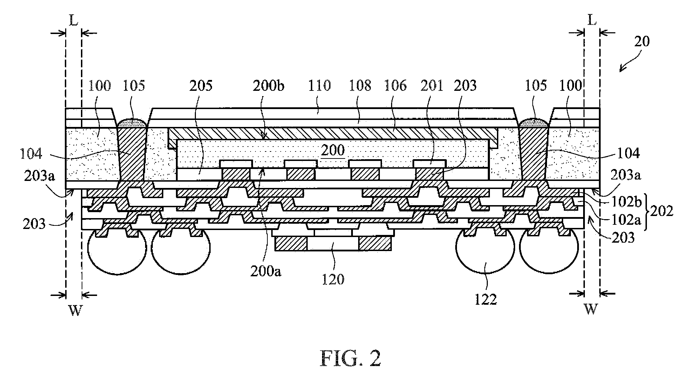

FIG. 2 is a cross-sectional view of a semiconductor package structure 20 in accordance with some embodiments of the disclosure. Descriptions of elements of the embodiments hereinafter that are the same as or similar to those previously described with reference to FIG. 1 may be omitted for brevity. In the embodiment, the semiconductor package structure 20 is similar to the semiconductor package structure 10 shown in FIG. 1, except the RDL structure 202. The RDL structure 202 includes an IMD layer 202a and conductive traces 202b that are the same as or similar to the IMD layer 102a and the conductive traces 102b, respectively, shown in FIG. 1. However, the opening 203 formed in the RDL structure 202 by lithography has a bottom 203a within the RDL structure 202. Namely, the opening 203 does not pass through the IMD layer 202a. In the embodiment, the opening 203 corresponds to the dicing lane region L and has a width W in a range of about 1 µm to 100µm.

In some embodiments, through vias are not formed in the molding compound 100. In this case, the second protective layer 108 can be removed, such that the first protective layer 110 is in direct contact with the adhesion layer 106.

According to the foregoing embodiment, since the molding compound corresponding to the opening of the RDL structure is not exposed, the molding compound loss caused by chemical etch processes used in the fabrication of the semiconductor package structure can be prevented.

Similarly, since the RDL structure has an opening defined by lithography, it does not need to perform a laser grooving process prior to the dicing process using a mechanical saw. As a result, the manufacturing cost can be reduced and the processes for the semiconductor package structure can be simplified. Moreover, polymer residues can be eliminated or mitigated, thereby preventing the mechanical saw from being contaminated. Since the opening also makes the RDL structure create a discontinuity surface, the warpage in the semiconductor package structure can be mitigated or improved by stress reduction.

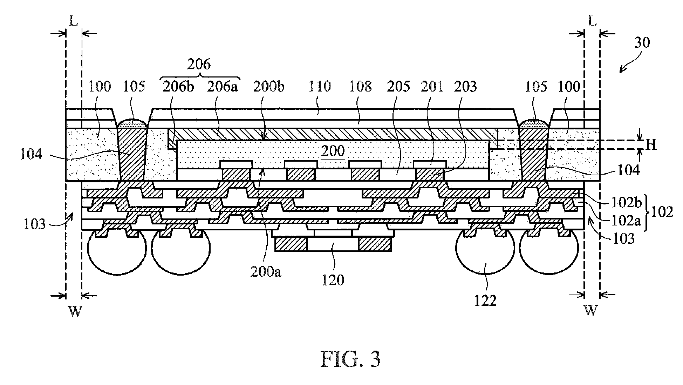

FIG. 3 is a cross-sectional view of a semiconductor package structure 30 in accordance with some embodiments of the disclosure. Descriptions of elements of the embodiments hereinafter that are the same as or similar to those previously described with reference to FIG. 1 may be omitted for brevity. In the embodiment, the semiconductor package structure 30 is similar to the semiconductor package structure 10 shown in FIG. 1, except the adhesion layer 206. In the embodiment, the adhesion layer 206 is U-shaped. The U-shaped adhesion layer 206 disposed on the second surface 200a of the semiconductor die has a plate portion 206a and a wall portion 206b on the plate portion 206a and at the edge thereof, such that the wall portion 206b covers a portion of the upper sidewall of the semiconductor die 200. In some embodiments, the wall portion 206b on the plate portion 206a has a height H in a range of about 1µm to 20µm. Namely, the U-shaped adhesion layer 206 extends along the sidewall of the semiconductor die 200 to a distance that is in a range of about 1µm to 20µm.

Similarly, the U-shaped adhesion layer 206 is also surrounded by the molding compound 100. The first protective layer 110 is disposed over the U-shaped adhesion layer 206 and the molding compound 100. Moreover, the second protective layer 108 is disposed between the first protective layer 110 and the U-shaped adhesion layer 206.

In the embodiment, the height H of the wall portion 206b of the U-shaped adhesion layer 206 can be adjusted by controlling the magnitude of a bonding force that is applied for attaching the semiconductor die 200 onto a carrier (not shown) via an adhesion layer (i.e., the adhesion layer 206). Namely, the height H of the wall portion 206b is in proportion to the magnitude of the bonding force.

In some embodiments, the RDL structure 102 can be replaced by the RDL structure 202 (as shown in FIG. 2), so as to have an opening without passing therethrough. In some embodiments, there is not an opening that corresponds to the dicing lane region L of the molding compound 100 in the RDL structure 102.

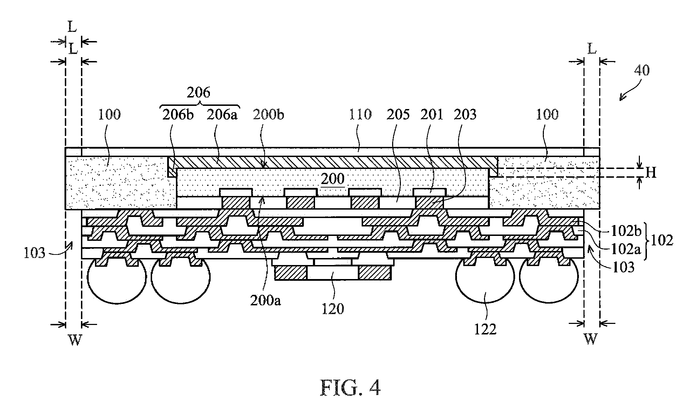

FIG. 4 is a cross-sectional view of a semiconductor package structure 40 in accordance with some embodiments of the disclosure. Descriptions of elements of the embodiments hereinafter that are the same as or similar to those previously described with reference to FIGS. 1 and 3 may be omitted for brevity. In the embodiment, the semiconductor package structure 40 is similar to the semiconductor package structure 30 shown in FIG. 3. In the embodiment, there is no through via formed in the molding compound 100. Moreover, compared to the semiconductor package structure 30, the second protective layer 108 between the first protective layer 110 and the semiconductor die 200 is removed, such that the first protective layer is in direct contact with the U-shaped adhesion layer 206 and extends to fully cover the upper surface of the molding compound 100.

In some embodiments, the RDL structure 102 can be replaced by the RDL structure 202 (as shown in FIG. 2), so as to have an opening without passing therethrough. In some embodiments, there is not an opening that corresponds to the dicing lane region L of the molding compound 100 in the RDL structure 102.

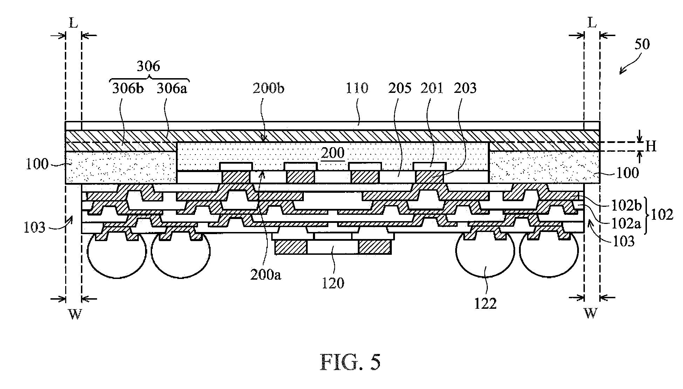

FIG. 5 is a cross-sectional view of a semiconductor package structure 50 in accordance with some embodiments of the disclosure. Descriptions of elements of the embodiments hereinafter that are the same as or similar to those previously described with reference to FIG. 4 may be omitted for brevity. In the embodiment, the semiconductor package structure 50 is similar to the semiconductor package structure 40 shown in FIG. 4, except the U-shaped adhesion layer 306. In the embodiment, the wall portion 306b on the plate portion 306a of U-shaped adhesion layer 306 extends to fully cover the upper surface of the molding compound 100. Namely, the U-shaped adhesion layer 306 is not surrounded by the molding compound 100.

In some embodiments, the RDL structure 102 can be replaced by the RDL structure 202 (as shown in FIG. 2), so as to have an opening without passing therethrough. In some embodiments, there is not an opening that corresponds to the dicing lane region L of the molding compound 100 in the RDL structure 102.

According to the foregoing embodiments, since the sidewall of the semiconductor die is partially covered by the wall portion of the U-shaped adhesion layer, the die shift problem during curing the adhesion layer can be eliminated or mitigated. Moreover, since a sufficient bonding force for die attachment is applied to form the U-shaped adhesion layer, the total thickness variation (TTV) of the die after performing die attachment and the subsequent planarization can be reduced. As a result, the reliability, yield, and throughput of the semiconductor package structure can be increased.

Similarly, since the RDL structure has an opening defined by lithography, it does not need to perform a laser grooving process prior to the dicing process using a mechanical saw. As a result, the manufacturing cost can be reduced and the processes for the semiconductor package structure can be simplified. Moreover, polymer residues can be eliminated or mitigated, thereby preventing the mechanical saw from being contaminated. Since the opening also makes the RDL structure create a discontinuity surface, the warpage in the semiconductor package structure can be mitigated or improved by stress reduction. Additionally, since the molding compound corresponding to the opening of the RDL structure may be not exposed, the molding compound loss caused by chemical etch processes used in the fabrication of the semiconductor package structure can be prevented.

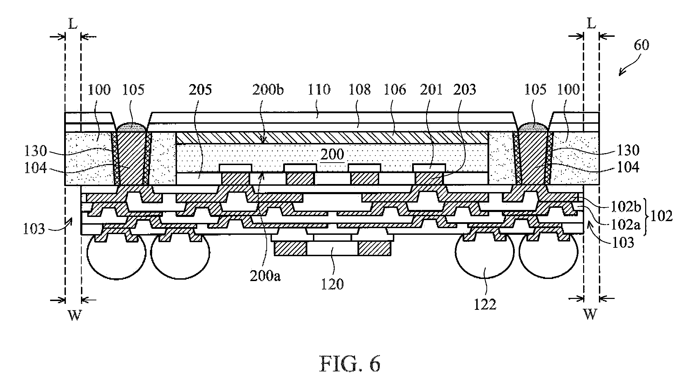

FIG. 6 is a cross-sectional view of a semiconductor package structure 60 in accordance with some embodiments of the disclosure. Descriptions of elements of the embodiments hereinafter that are the same as or similar to those previously described with reference to FIG. 1 may be omitted for brevity. In the embodiment, the semiconductor package structure 60 is similar to the semiconductor package structure 10 shown in FIG. 1. In the embodiment, a barrier layer 130 is disposed between the molding compound 100 and the through via 104. The barrier layer 130 provides a sufficient adhesion between the molding compound 100 and the through via 104, thereby preventing the molding compound 100 and the through via 104 from being delaminated. Moreover, the barrier layer 130 also prevents the metal atoms in the through via 104 from diffusing into the molding compound 100. Additionally, the barrier layer 130 further reduces or eliminates the metal smear from the through via 104 that is formed while performing a planarization process for formation of the through via 104, thereby preventing the through vias 104 with fine pitch from bridging.

In some embodiments, the barrier layer 130 may comprise copper oxide (e.g., CuO, Cu₂O, or Cu₂O₃), titanium oxide (e.g., TiO), or aluminum oxide (e.g., Al₂O₃). In some embodiments, the barrier layer 130 may comprise silicon oxide (e.g., SiO or SiO₂), silicon carbide (e.g., SiC), or silicon oxynitride (e.g., SiOₓN_{y}). In these cases, the barrier layer 130 may be formed by chemical vapor deposition (CVD), physical vapor deposition (PVD), plasma deposition, spin coating, furnace oxidation or other suitable deposition.

In some embodiments, the RDL structure 102 can be replaced by the RDL structure 202 (as shown in FIG. 2), so as to have an opening without passing therethrough. In some embodiments, there is not an opening that corresponds to the dicing lane region L of the molding compound 100 in the RDL structure 102.

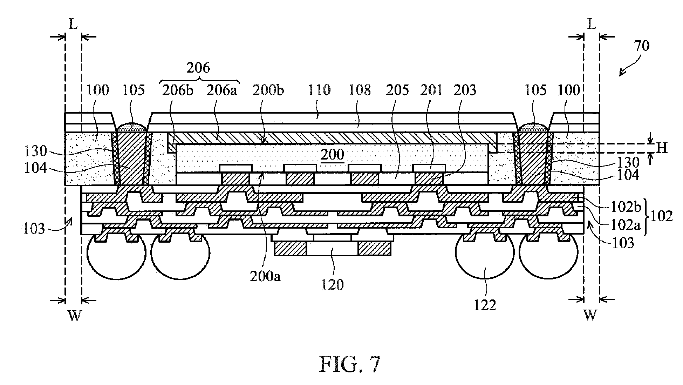

In some embodiments, the adhesion layer 106 can be replaced by the U-shaped adhesion layer 206 shown in FIG. 3, as shown in FIG. 7.

According to the foregoing embodiments, since a barrier layer is formed between the molding compound and the through via, the reliability of the semiconductor package structure can be increased.

Similarly, since the sidewall of the semiconductor die is partially covered by the wall portion of the U-shaped adhesion layer, the die shift problem during curing the adhesion layer can be eliminated or mitigated. Moreover, since a sufficient bonding force for die attachment is applied to form the U-shaped adhesion layer, the total thickness variation (TTV) of the die after performing die attachment and the subsequent planarization can be reduced. As a result, the reliability, yield and throughput of the semiconductor package structure can be increased.

Moreover, since the RDL structure has an opening defined by lithography, it does not need to perform a laser grooving process prior to the dicing process using a mechanical saw. As a result, the manufacturing cost can be reduced and the processes for the semiconductor package structure can be simplified. Moreover, polymer residues can be eliminated or mitigated, thereby preventing the mechanical saw from being contaminated. Since the opening also makes the RDL structure create a discontinuity surface, the warpage in the semiconductor package structure can be mitigated or improved by stress reduction. Additionally, since the molding compound corresponding to the opening of the RDL structure may be not exposed, the molding compound loss caused by chemical etch processes used in the fabrication of the semiconductor package structure can be prevented.

While the invention has been described by way of example and in terms of the preferred embodiments, it is to be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A semiconductor package structure, comprising:
a molding compound having a dicing lane region;
a semiconductor die disposed in the molding compound and surrounded by the dicing lane region, wherein the semiconductor die has a first surface and a second surface opposite thereto, and the first and second surfaces are exposed from the molding compound; and
a redistribution layer (RDL) structure disposed on the first surface of the semiconductor die and covering the molding compound, wherein the RDL structure comprises a photo-sensitive material and has an opening aligned with the dicing lane region.

2. The semiconductor package structure as claimed in claim 1, wherein the opening passes through the RDL structure, so that the molding compound corresponding to the dicing lane region is exposed by the opening.

3. The semiconductor package structure as claimed in claim 1, wherein the opening has a bottom within the RDL structure.

4. The semiconductor package structure as claimed in claim 1, wherein the opening has a width in a range of about 1µm to 100µm.

5. The semiconductor package structure as claimed in claim 1, further comprising a passive device disposed on and electrically coupled to the RDL structure.

6. The semiconductor package structure as claimed in claim 1, further comprising a plurality of bumps disposed on and electrically coupled to the RDL structure.

7. The semiconductor package structure as claimed in claim 1, further comprising:
a first protective layer disposed over the second surface of the semiconductor die and the molding compound; and
an adhesion layer disposed between the first protective layer and the semiconductor die.

8. The semiconductor package structure as claimed in claim 7, further comprising a second protective layer disposed between the first protective layer and the adhesion layer.

9. The semiconductor package structure as claimed in claim 1, further comprising at least one through via passing through the molding compound and electrically coupled to the RDL structure.

10. A semiconductor package structure according to one of the preceding claims, comprising:
a U-shaped adhesion layer disposed on the second surface of the semiconductor die, wherein the U-shaped adhesion layer has a plate portion and a wall portion on an edge of the plate portion, such that the wall portion covers a portion of a sidewall of the semiconductor die.

11. The semiconductor package structure as claimed in claim 10, wherein the wall portion on the plate portion has a height in a range of about 1µm to 20µm.

12. The semiconductor package structure as claimed in claim 10, wherein the wall
portion is surrounded by the molding compound, and/or
wherein the wall portion is disposed on the molding compound.

13. The semiconductor package structure as claimed in in one of claims 10 to 12, further comprising a first protective layer disposed over the U-shaped adhesion layer and the molding compound, wherein said semiconductor package structure preferably further comprises a second protective layer disposed between the first protective layer and the U-shaped adhesion layer, wherein said semiconductor package structure preferably further comprises at least one through via passing through the molding compound and electrically coupled to the RDL structure, wherein the first and second protective layers preferably have openings, respectively, to expose the at least one through via.

14. The semiconductor package structure as claimed in one of claims 9 to 13, comprising:
a barrier layer disposed between the molding compound and the at least one through via, wherein said semiconductor package structure preferably further comprises a plurality of bumps disposed on and electrically coupled to the RDL structure.

15. The semiconductor package structure as claimed in claim 14, further comprising:
a first protective layer disposed over the second surface of the semiconductor die and the molding compound; and
an adhesion layer disposed between the first protective layer and the semiconductor die and surrounded by the molding compound; and
a second protective layer disposed between the first protective layer and the adhesion
layer and on the molding compound, wherein the adhesion layer preferably is U-shaped and preferably has a plate portion and a wall portion on an edge of the plate portion, such that the wall portion covers a portion of a sidewall of the semiconductor die,
wherein the first and second protective layers preferably have openings, respectively,
to expose the at least one through via, and/or
wherein the barrier layer comprises copper oxide, titanium oxide, or aluminum oxide, and/or wherein the barrier layer comprises silicon oxide, silicon carbide, or silicon oxynitride.
